# EUROPEAN PATENT APPLICATION

(11) **EP 2 802 007 A1**
(43) Date of publication of application: **12.11.2014**
(21) Application number: 13166986.3
(22) Date of filing: 08.05.2013
(51) Int. Cl.: H01L 23/49, H01L 29/78

(54) **Power semiconductor module**

(71) Applicant: ABB Technology AG, 8050 Zürich (CH)
(72) Inventor: Hartmann, Samuel, 5603 Staufen (CH); Oezkol, Emre, 8048 Zürich-Altstetten (CH)
(74) Representative: ABB Patent Attorneys

(57) **Abstract**

The present invention relates to a power semiconductor module (10) comprising a substrate (12), on which substrate (12) at least one power semiconductor device (14) is located, wherein the at least one power semiconductor device (14) is electrically connected to a circuit path (16) via at least one bond wire (18), wherein at least one bond wire (18) comprises at least two bond wire feet (20) for attaching the bond wire (18) to a contact (22) of the power semiconductor device (14), wherein the bond wire (18) has a diameter d₁, and wherein the contact (22) is at least partly surrounded by a termination (32), wherein a first bond wire foot (20a) is located at a distance d₂ to the termination (32), and wherein the distance d₂ between the termination (32) and the first bond wire foot (20a) lies in the range of d₂ ≥ 1,5d₁ to d₂ ≤ 10d₁. A power module (10) according to the invention provides an improved bonding layout with regard to thermal management, reliability as well as security.

## Description

### Technical Field

The Invention relates to a power semiconductor module. In particular, the invention relates to a power semiconductor module comprising at least one power semiconductor device with an improved electrical connection to a circuit path. The present invention further relates to a power semiconductor arrangement comprising such a power semiconductor module.

### Background Art

A variety of power semiconductor modules are known and used in many different electronic devices. Power semiconductor modules comprise a substrate with a plurality of circuit paths on which power semiconductor devices are arranged and connected thereto, respectively. Often, these semiconductor devices are connected to circuit paths by means of bond wires. Secure bond wiring thereby contributes to long term stability as well as safety of the power semiconductor modules.

It is known to electrically contact power semiconductor devices, or their emitter contacts, respectively, with a circuit path by means of so-called stitch bonds. This kind of bonding provides a plurality of connection points of the bond wire to the power semiconductor device. This may enhance the stability of the respective bonding.

Known from EP 2 159 834 A1, for example, is a semiconductor device which comprises an electrical connection with a plurality of bond wire feet connecting a chip of the semiconductor device. According to this document, each foot has a coating that attaches the bond wire to the chip, wherein the coating is electrically conductive.

Known from DE 10 2005 039 940 B4 is further a power semiconductor module comprising a bonded electrical connection of a power semiconductor device to a circuit path. The bonding connection comprises a plurality of bond wires, wherein a plurality of bond feet of adjacent bond wires is arranged in a chessboard-like manner.

However, the bonding techniques like described above still have potential for improvements.

### Summary of invention

It is an object of the present invention to provide a power semiconductor module comprising at least one power semiconductor device with an improved electrical connection to a circuit path. In detail, it is an object of the present invention to provide a power semiconductor module providing an improved long-term stability and/or security.

These objects are achieved by a power semiconductor module according to claim 1. These objects are furthermore achieved by a power semiconductor arrangement according to claim 10. Preferred embodiments of the present invention are defined in the dependent claims.

The invention relates to a power semiconductor module comprising a substrate, on which substrate at least one power semiconductor device is located, wherein the at least one power semiconductor device is electrically connected to a circuit path via at least one bond wire, wherein at least one bond wire comprises at least two bond wire feet for attaching the bond wire to a contact of the power semiconductor device, wherein the bond wire has a diameter d₁, and wherein the contact is at least partly surrounded by a termination, wherein a first bond wire foot is located at a distance d₂ to the termination, and wherein the distance d₂ between the termination and the first bond wire foot lies in the range of d₂ ≥ 1,5d₁ to d₂ ≤ 6d₁.

Such a power semiconductor module may provide an improved long-term stability and thus reliability and additionally improved security behaviour.

In detail, the power semiconductor module comprises a substrate, on which substrate at least one power semiconductor device is located. The substrate may generally be any substrate known in the art for power semiconductor modules. For example, the substrate may be formed of an insulating material, such as of a ceramic material. As non-limiting examples, the substrate may be formed from aluminium nitride (AIN), silicon nitride (Si₃N₄) or aluminium oxide (Al₂O₃). On the surface of the substrate, a plurality of circuit paths may be provided like generally known in the art. Such circuit paths may for example be formed from a metallization, such as a copper metallization. The metal, such as the copper, may be arranged on the substrate by physical or chemical deposition methods, for example.

Further, at least one, preferably a plurality of power semiconductor devices is arranged on the substrate, or a circuit path, respectively, and electrically connected thereto by means of their collector contact. Further the power semiconductor devices are connected via their emitter contact to a further circuit path, such as to the circuit path carrying the load current, via at least one bond wire. Preferably, a plurality of bond wires may be provided in order to electrically connect a power semiconductor device, or its emitter contact, respectively, with said circuit path.

With respect to the power semiconductor device, the latter may generally be provided as known in the art for power semiconductor modules, or power semiconductor arrangements, respectively. For example, the power semiconductor device may be an insulated gate bipolar transistor (IGBT), a reverse conductive insulated gate bipolar transistor (reverse conducting IGBT), bi-mode insulated gate transistor (BIGT) and /or a diode, such as a Schottky diode. Further and in order to let the power semiconductor module and thus the power semiconductor arrangement work especially properly, more than one semiconductor device may be present. For example, a plurality of the same or of different power semiconductor devices may be present. As a non-limiting example, an IGBT and a diode may be present in one module.

Further, a power semiconductor device may be particularly suitable for power electronics which may exemplary and typicaly refer to applications working with currents of more than approximately 74A and voltages of more than approximately 100V, the before named values being exemplary values only.

Regarding the electric connection between the power semiconductor device and the circuit path, the latter is arranged by at least one bond wire such as by an aluminium bond wire. The bond wire has a diameter d₁. Such a diameter may particularly be the average diameter of the bond wire. This may be the case both for exactly round bond wires as well as for bond wires deviating from the exact round form and thus cross-section. Especially in the latter case the diameter shall be the averaged diameter taking into consideration all thicknesses of the diameter. It is thereby noted that the diameter of the pure bond wire is meant, without any additional parts, such as bond wire feet, like will be described down below.

The bond wire comprises at least two bond wire feet for attaching the bond wire to a surface of the power semiconductor device, or its emitter contact, respectively. Such a wire foot is particularly a connection point of the bond wire to the semiconductor device, or its contact, respectively. In other words, the bond wire is fixed to the power semiconductor device, or its contact, respectively, these connection points being called bond wire feet. The latter arrangement may be described as a so-called stitch-bonding.

Preferably, the bond wire is attached to the power semiconductor device, or its contact, respectively, by welding. In other words, the bond wire feet are formed by welding the bond wire to the surface of the power semiconductor device. According to this, the bond wire may be attached and fixed to the surface of the power semiconductor device in an especially easy and cost-saving manner which also allows an automated manufacturing process. Apart from that, the bond wire feet are formed such that the current may flow through the respective feet without major resistivity. As a result, the heat formation due to high currents may be strongly reduced so that the reliability as well as security behaviour may be additionally improved.

Particularly, a plurality of bond wire feet are arranged subsequently essentially in a direction from the edge of the contact of the power semiconductor device, or its surface, respectively, being directed towards the circuit path, to the opposite direction of the power semiconductor device.

According to this, the bond wire foot being located closest to the edge of the contact of the power semiconductor device being directed towards the circuit path, which in the further application is called the first bond wire foot, is located at a distance d₂ to a termination of the power semiconductor device.

According to this, a termination of the power semiconductor device may particularly be a feature which as well may be called a guard ring and it may be formed as a one part structure or it may be formed as a multi-part structure as it is generally known for one skilled in the art. The termination may have the potential of the collector electrode and thus a different potential compared to the emitter electrode which is connected by the bond wires.

According to the invention, the distance d₂ between the termination and the first bond wire foot lies in the range of d₂ ≥ 1,5d₁ to d₂ ≤ 6d₁ with d₂ = 2d₁ being an exemplary example.

In other words, the distance d₂ of the first bond wire foot to the termination of the power semiconductor device and thus the location of the first bond wire foot is chosen in dependence of the diameter of the bond wire. According to this, a plurality of advantages may be achieved.

In detail, that part of the wire that carries the highest current, i.e. the one which is directly located between the outermost bonding foot, i.e. the first bond wire foot, and the circuit path, or circuit board, respectively, is minimized by length due to the comparably low length of d₂. This reduces the bond wire temperature as well as the danger of forming hot spots considerably. A shorter length thereby leads to lower resistance and thus less heat produced in the wire and it thus shortens the cooling path along the bond wire. According to this, no or at least a significantly reduced amount of heat is transferred into potentially arranged surrounding silicone gel because of its bad thermal conductivity.

Further, power semiconductor devices may provide elevated temperatures, or generate heat, respectively, during an operation of the power semiconductor module, or the power semiconductor device, respectively. However, the heat may be generated in a comparably greater amount at the centre, or the middle part, respectively, of the power semiconductor device, whereas the edge may provide a comparably cooler temperature. Therefore, due to the comparably low length of d₂, the heat influence to the bond wire feet is significantly lowered and in fact under circumstances the bond wire may be cooled by the surface of the power semiconductor device. According to this, the stability of the bonding connection is as well significantly improved.

Accordingly, the above further allows the module to be less sensitive against temperature cycling and thus power cycling. This in turn allows providing a significantly improved long-term stability and thus reliability. This may be especially advantageous due to the fact that depending on the specific application, rather long service-free working times of the power semiconductor modules are required. In case a module fails, however, time-intensive as well as cost-intensive measures are required which may be avoided or at least reduced according to the invention.

Further, in case of temperature-based damages, such malfunctions are often accompanied with a security problem. Therefore, in case the resistance against temperature influences and thus temperature cycling is improved, the resistance against failures being relevant with respect to security are also reduced.

When considering the above, next to reliability as well as security advantages, a module like described above may further provide the capability of withstanding even higher currents being used. This may be especially advantageous with respect to the fact the especially the capability of carrying current in combination with temperature management may be important for being suitable for high class applications using high currents and high voltages.

According to an embodiment, at least one bond wire has a diameter d₁ in the range of ≥ 300µm to ≤ 500µm. For example, at least one bond wire has a diameter in the range of ≥ 370µm to ≤ 410µm, for example 385µm. Preferably, all bond wires present connecting the contact of one or more than one power semiconductor devices with a circuit path have the afore-mentioned diameters. According to this embodiment, the bond wires are arranged for withstanding even high currents making them suitable especially for power semiconductor applications. Further, these diameters d₁ and accordingly the distance d₂ may provide an especially preferred resistance against temperature and further temperature cycling allowing an especially good reliability as well as security for power applications.

According to a further embodiment, a minimum distance d₃ between the edge of the contact being directed towards the circuit path and the bond wire in a perpendicular direction of the edge of the contact lies in the range of ≥ (voltage used/3KV) * 1 mm to ≤ 3mm + (voltage used/3KV) * 1 mm. Thereby, appropriate voltages being used by a performance of the respective power semiconductor module may in a non-limiting example be in the range of ≥ 1,7kV to ≤ 2,5kV with the distance d₃ being chosen accordingly. For example, the minimum distance d₃ between the edge of the contact being directed towards the circuit path and the bond wire in a perpendicular direction of the edge of the contact is 0,5mm + (voltage used/3KV) * 1mm.

According to this, a perpendicular direction of the edge of the contact shall particularly mean a perfect perpendicular direction, or the direction may vary in a range of +/- 20°, particularly +/- 10°, the perpendicular direction being chosen with regard to the upper surface of the contact of the semiconductor device, as will be clearly understood by one skilled in the art.

According to this embodiment, the temperature influence from the contact to the bond wire may be especially reduced.

In detail, due to the comparably large distance d₃ between the edge of the power semiconductor device and the bond wire, this allows the bond wire being located with a comparably large distance from the power semiconductor contact. Therefore, the temperature influence from the power semiconductor device to the bond wire may not only be reduced at the terminal foot but further to these regions, which are not directly mechanically bond to the power semiconductor device.

Apart from that, especially the combination of the distance d₃ and the distance d₂ may be advantageous in order to improve the long-term stability. In fact, the bonding wires often are formed of a metal material with a suitable thickness, or diameter, respectively. The combination of d₃ and d₂ thereby allows an essentially stress-free bending of the wire allowing an easy manufacturing without exerting high stresses on the bonding wire. This additionally may improve the reliability of the module.

According to a further embodiment, at least one bond wire proceeds from the first bond wire foot in a direction towards the circuit path with an angle α with respect to the upper surface of the contact of equal or more than 50°. Preferably, the bond wire proceeds from the first bond wire foot and thus of the foot of the bond wire being located closest to the termination of the power semiconductor device being directed towards the circuit path in a direction towards the circuit path and thus towards the circuit path the power semiconductor device is connected to with an angle α with respect to the surface of equal or more than 50° to less than 80°, regarding the upper surface of the emitter contact of the semiconductor device. According to this embodiment, it may be allowed that the bond wire has a great distance to the surface of the power semiconductor device in a low distance with regard to the direction of the circuit path. Therefore, the reliability as well as the security behaviour of the power module may be especially high. Further, the bond wires may be fixed to the surface of the power semiconductor device in an easy manner thereby still being capable of an automated manufacturing process.

According to a further embodiment, at least one power semiconductor device is electrically connected to a circuit path via two or more bond wires, wherein a distance d₄ between two bond wire feet of adjacent bond wires lies in a range of ≤ 2mm. Preferably, at least one power semiconductor device is electrically connected to a circuit path via two or more bond wires, wherein the distance d₄ between two bond wire feet of adjacent bond wires lies in a range of ≥ 0,6m to ≤ 2mm. According to this embodiment, an advantageous current equilibration may be achieved. In detail, a bond wire which potentially is carrying comparably high currents can transfer some current to the neighbouring wire that potentially carries less current via the respective bonding feet having the appropriate distance. This leads to a current equilibration of a potentially present current imbalance. Therefore, local hot spots due to comparably high amounts of current may be avoided which again further improves the reliability as well as the security behaviour of the module. This embodiment may be especially preferred in case the distance d₄ of two first bond wire feet of adjacent bond wires lies in the aforedefined range. This is due to the fact that especially the first bond wire foot carries an especially high amount of current because of which a current equilibration may be especially effective.

According to a further embodiment, at least one power semiconductor device is electrically connected to a circuit path via two or more bond wires, wherein between two first bond wire feet of adjacent bond wires is a distance d₄ and wherein between at least two subsequent adjacent bond wire feet having the same priority is distance d₅, wherein d₅ is ≥ 2d₄. Preferably, d₅ is ≥ 3d₄ with d₅ being ≥ 3d₄ to d₅ ≤ 4d₄ as exemplary but in no way limiting examples. In other words, the distance d₄ between two bond wire feet being located closest to the termination of the power semiconductor device being directed towards the circuit path is smaller compared to the distance d₅ of two further bond wire feet having the same priority of adjacent bond wires, or neighbouring bond wires, respectively, such as of at least two second, two third and/or further two respective bond wire feet, coming from the direction of the circuit path. This embodiment may be realized, for example, in case the distance between two subsequent bond wire feet in one bond wire is different with respect to the same difference in an adjacent bond wire. According to this embodiment, an especially uniform current density across the contact of the semiconductor device may be achieved due to the fact that the bond wire feet may be spread over the whole surface of the power semiconductor device, or its contact, respectively. Therefore a high reliability as well a security behaviour may be achieved in a very cost-saving manner.

According to a further embodiment, at least one bond wire at least partly does not proceed parallel to at least one further bond wire. Preferably, at least one bond wire does not proceed parallel to at least one further bond wire, the two respective bond wires being arranged adjacent to each other. This may be achieved, for example, by optionally changing the direction in which the respective bond wires proceed independently from each other. A divergent direction of the respective bond wires may thereby be arranged starting from the first bond wire foot, i.e. in the direction across the surface of the power semiconductor device starting from that bond wire foot which is located closest to the termination of the power semiconductor device being directed towards the circuit path. With respect to the region between that first bond wire foot and the circuit path, the bond wires may proceed parallel. Therefore, two bond wires proceed in part parallel and in part not parallel. According to this embodiment, a superb distribution of the bond wires, and particularly the bond wire feet, across the surface of the power semiconductor device, or its contact, respectively, may be achieved. This again may result in a very uniform current density across the surface of the power semiconductor device which reduces the danger of hot spots and thus further improves the reliability as well as security behaviour of the power semiconductor module.

According to a further embodiment, at least one power semiconductor device is electrically connected to a circuit path via two or more bond wires, wherein at least two bond wires are provided having a different length. According to this embodiment, again a very uniform current density over the whole surface of the power semiconductor device may be achieved, thereby saving material of the bond wires. As a result, according to this embodiment, an especially high reliability and security behaviour may be combined with an especially cost-saving manufacturing process of the power semiconductor module.

According to a further embodiment, at least one power semiconductor device is electrically connected to a circuit path via two or more bond wires, wherein at least two different bond wires are provided having a different number of bond wire feet. According to this embodiment, again a very uniform current density over the whole surface of the power semiconductor device may be achieved, thereby allowing an especially easy manufacturing process of the bond wires. As a result, according to this embodiment an especially high reliability and security behaviour may be combined with an especially cost-saving manufacturing process of the power semiconductor module.

With respect to further technical features and advantages of the described power module it is referred to the description of the power semiconductor arrangement as well as to the figures.

The invention furthermore relates to a power semiconductor arrangement comprising a plurality of power semiconductor modules according to the invention.

Such a power semiconductor arrangement may be arranged for carrying even high amounts of currents and voltages, so that that the power arrangement is suitable for exceptional high power applications. Further, the high current carrying capability may be combined with a superb reliability behaviour as well as security behaviour allowing the arrangement to be used in a plurality of applications. Such an arrangement may comprise a plurality and thus two or more, as a non-limiting example 2 to 6, power semiconductor modules.

Such a power semiconductor arrangement may be part of an electric device which is designed for carrying even high amounts of currents and voltages, so that the power module arrangement is suitable for exceptional high power applications. Exemplary and non-limiting applications comprise inverters such as traction inverters in trains. However, the invention is in no way limited to the above defined applications.

With respect to further technical features and advantages of the described power semiconductor arrangement it is referred to the description of the power semiconductor module the as well as to the figures.

### Brief description of drawings

Additional features, characteristics and advantages of the subject-matter of the invention are disclosed in the subclaims, the figures and the following description of the respective figures and examples, which -in an exemplary fashion- show embodiments and examples of a semiconductor module according to the invention.

In the figures:

Figure 1 shows a schematic top view of an embodiment of a power semiconductor module according to the invention;

Figure 2 shows a schematic sectional side view of an embodiment of a power semiconductor module according to the invention;

Figure 3 shows a schematic top view of a power semiconductor device with a bond layout according to the invention; and

Figure 4 shows a schematic top view of a power semiconductor device with a further bond layout according to the invention.

### Description of embodiments

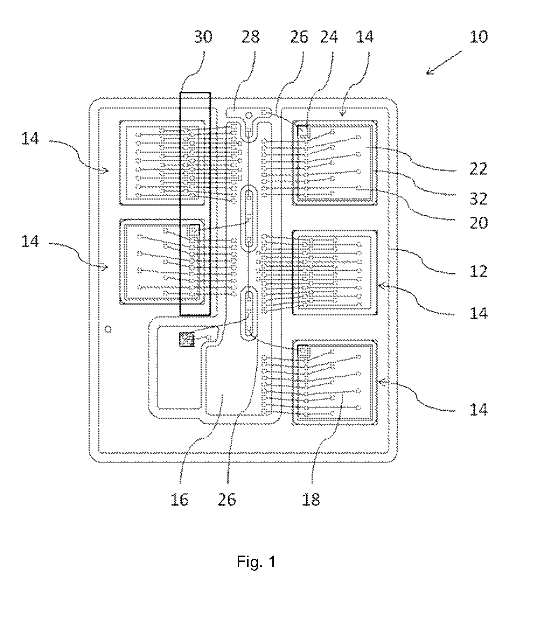

In figure 1, an embodiment of a power semiconductor module 10 according to the invention is schematically shown. It is obvious for one skilled in the art that a plurality of modules 10 shown in figure 1 may be combined to a power semiconductor arrangement. The module 10 according to the invention is particularly suitable for high-voltage applications, or high current applications, respectively.

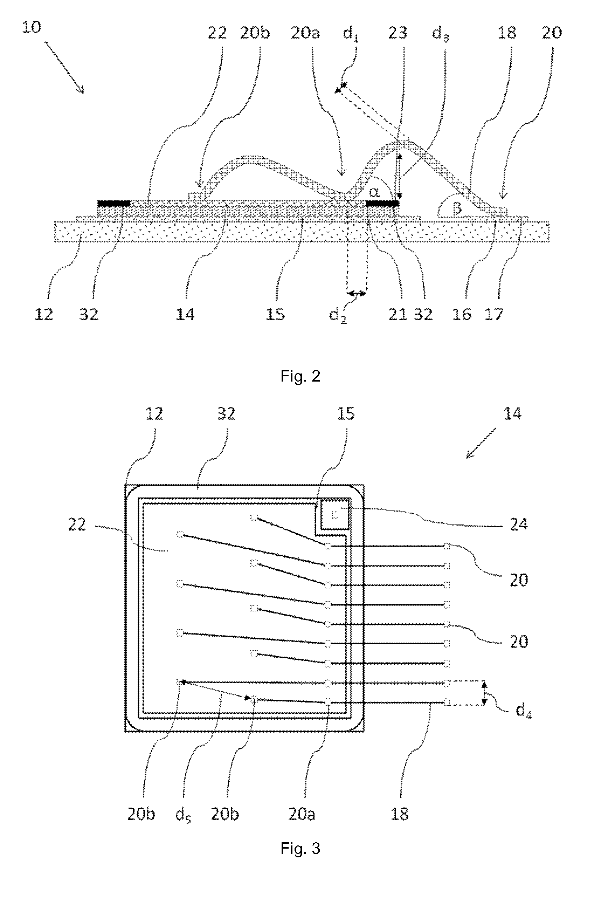

The power semiconductor module 10 comprises a substrate 12, on which substrate 12 a plurality of metallizations are formed, these metallizations in turn forming circuit paths. Further, at least one power semiconductor device 14 is located on a metallization 15. Preferably, a plurality of power semiconductor devices 14 is located on a substrate 12, such as 4-5 power semiconductor devices 14. According to figure 2, five power semiconductor devices 14 are provided. The power semiconductor devices 14 are electrically connected to a circuit path 16 via at least one bond wire 18, according to figure 1 by a plurality of bond wires 18. At least one bond wire 18 comprises at least two bond wire feet 20 for attaching the bond wire 18 to a contact 22 of the power semiconductor device 14. In other words, the bond layout is realized by using stitch bonds and thus at least two bond wire feet 20 on the contact 22, or chip, respectively, per wire 18. The bond wire feet 20 of different bond wires 18 which are located closest to the termination 32 of the power semiconductor device 14 being directed towards the circuit path 16, and thus the first bond wire feet 20a of respective power semiconductor devices 14, are highlighted by box 30. It can however be seen that the ends of the bond wires 18 are distributed on the whole bond pad, or contact 22, respectively. It can further be seen that the semiconductor devices 14 are electrically connected via a metallization 24 by bond wires 26 to a control circuit 28.

The exact bonding layout of bonding wires 18 and the bond wire feet 20 on the contact 22 may be indicated in figure 1 and is described in more detail in the subsequent figures.

In figure 2, the bond layout is shown in more detail. According to figure 2, the substrate 12 with a power semiconductor device 14 is shown, wherein the power semiconductor device 14 is connected to the substrate 12 by means of the metallization 15. The power semiconductor device 14 is further connected to the circuit path 16, which as well may be formed by a metallization, by means of one or more bond wires 18. The bond wire 18 is thereby connected to the contact 22, such as the emitter contact, of the power semiconductor device 14, by two bond wire feet 20. In detail the first bond wire foot 20a and the second bond wire foot 20b are shown.

It can be estimated from figure 2 that a first bond wire foot 20a is located at a distance d₂ to the termination 32, and that the distance d₂ between the termination 32 and the first bond wire foot 20a, and thus the distance between the respective outer points of the termination 32 and the bond wire foot 20a, lies in the range of d₂ ≥ 1,5d₁ to d₂ ≤ 6d₁, d₁ being the diameter of the bond wire 18. Further, it may be provided that at least one bond wire 20 has a diameter d₁ in the range of ≥ 300µm to ≤ 500µm.

Apart from that, the minimum distance d₃ between the edge 21 of the contact 22 being directed towards the circuit path 16 and the bond wire 18 in a perpendicular direction of the edge 21 of the contact 22 lies in the range of ≥ (voltage used/3KV) * 1 mm to ≤ 3mm + (voltage used/3KV) * 1 mm. Especially the above values are advantageous for shifting the location of the bond wire 18 with the highest point right above the contacts termination 32. Finally the distance between bond wire 18 and termination 32 is increased.

According to figure 2, it may further be seen that the bond wire 18 proceeds from the first bond wire foot 20a in a direction towards the circuit path 16 with an angle α with respect to the upper surface 23 of the contact 22 of equal or more than 50°. Additionally, the bond wire 18 may proceed from the circuit path 16 in the direction to the semiconductor device 14 in an angle β referring to the upper surface 17 of the circuit path 16 lying in the range β ≥ α. For typical bond layouts this may enhance to reach a small distance between the first bond wire foot 20a and the termination 32 with an easy manufacturing process and further good thermal management. This can additionally avoid a small insulation distance which can lead to loss of voltage blocking capability.

It is hereby advantageous to start bonding the bond wire 18 on the chip, or on the contact 22, respectively, and end the bond wire 18 on the substrate 12, or the circuit path 16, respectively, where the bond wire 18 can be cut without risk of chip damage. However the achievable loop shape of the bond wire 18 may depend on the wiring direction.

The above bond layout has significant advantages with respect to thermal management and thus with security as well as reliability.

This may be estimated in a schematic manner as follows. Starting form an average temperature, in power cycling experiments it was observed that the probability of bond wire lift-off correlates with the temperature of the contact 22 at the location of the bond wire 18, or bond wire foot 20, respectively. This correlation may be described regarding the percentage of detached bond wires 18 against the temperature of the surface of the contact 22. Already a temperature rise of 15°C compared to a relative temperature, particularly the standard working temperature, may lead to an increase of up to 30% of bond wire lift-offs. On the other hand, a temperature decrease of 15°C may lead to a decrease of bond wire lift-offs of up to 30%. This clearly demonstrates that temperature management may have a significant influence on reliability as well as security of the module 10.

In figure 3 an embodiment of a bond layout is shown in detail. According to figure 3 it can be seen that at least one power semiconductor device 14 is electrically connected to a circuit path 16 via two or more bond wires 18, wherein the distance d₄ between two first bond wire feet 20a of adjacent bond wires 18 lies in a range of ≤ 2mm. This is especially advantageous for current equilibration between the respective bond wire feet 20a and thus between the respective bond wires 18. Additionally, it can be seen that at least one power semiconductor device 14 is electrically connected to a circuit path 16 via two or more bond wires 18, wherein at least two bond wires 18 are provided having a different length. The bond layout according to figure 3 further shows that at least one power semiconductor device 14 is electrically connected to a circuit path 16 via two or more bond wires 18, wherein between two first bond wire feet 20a of adjacent bond wires 18 is a distance d₄ and wherein between at least two subsequent adjacent bond wire feet 20b having the same priority is distance d₅, wherein d₅ ≥ 2d₄ and further that at least one bond wire 18 at least partly does not proceed parallel to at least one further bond wire 18.

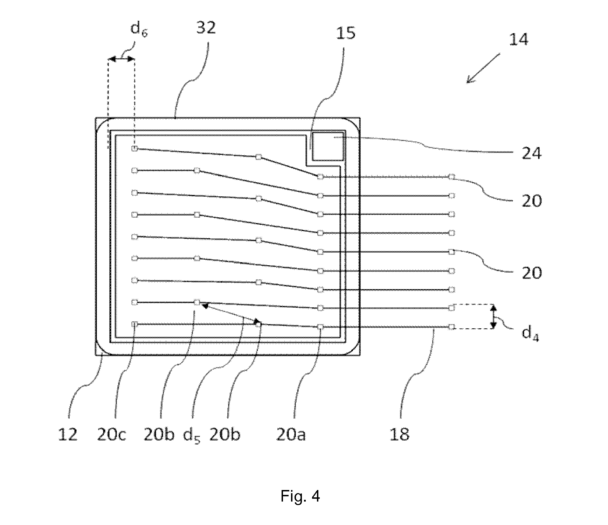

In figure 4, a further embodiment of a bond layout is shown. According to figure 4, essentially the same features may be provided according to figure 3 with a comparable bond layout. It is thus referred to the respective description of figure 3. However, according to figure 4, it can further be seen that the last bond wire feet 20c are arranged in a distance d₆ from the termination 32 being located opposite to the circuit path 16, which distance d₆ is as well chosen in small dimensions. For example, the dimension d₆ may be chosen in the same range as described above with respect to the dimension d₂. According to this, again the heat influence acting on these bond wire feet 20c is significantly reduced allowing the advantages as described above with respect to choosing the distance d₂ may be provided.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

**Reference signs list**

| | |
|---|---|
| 10 | power semiconductor module |
| 12 | substrate |
| 14 | power semiconductor device |
| 15 | metallization |
| 16 | circuit path |
| 17 | upper surface |
| 18 | bond wire |
| 20 | bond wire foot |
| 21 | edge |
| 20a | first bond wire foot |
| 20b | second bond wire foot |
| 20c | last bond wire foot |
| 22 | contact |
| 23 | upper surface |
| 24 | metallization |
| 26 | bond wire |
| 28 | control circuit |
| 30 | box |
| 32 | termination |

## Claims

1. Power semiconductor module comprising a substrate (12), on which substrate (12) at least one power semiconductor device (14) is located, wherein the at least one power semiconductor device (14) is electrically connected to a circuit path (16) via at least one bond wire (18), wherein at least one bond wire (18) comprises at least two bond wire feet (20) for attaching the bond wire (18) to a contact (22) of the power semiconductor device (14), wherein the bond wire (18) has a diameter d₁, and wherein the contact (22) is at least partly surrounded by a termination (32), wherein a first bond wire foot (20a) is located at a distance d₂ to the termination (32), and wherein the distance d₂ between the termination (32) and the first bond wire foot (20a) lies in the range of d₂ ≥ 1,5d₁ to d₂ ≤ 6d₁.

2. Power semiconductor module according to claim 1, wherein at least one bond wire (18) has a diameter d₁ in the range of ≥ 300µm to ≤ 500µm.

3. Power semiconductor module according to any of claims 1 or 2, wherein a minimum distance d₃ between the edge (21) of the contact (22) being directed towards the circuit path (16) and the bond wire (18) in a perpendicular direction of the edge (21) of the contact (22) lies in the range of ≥ (voltage used/3KV) * 1 mm to ≤ 3mm + (voltage used/3KV) * 1 mm.

4. Power semiconductor module according to any of the preceding claims, wherein at least one bond wire (18) proceeds from the first bond wire foot (20a) in a direction towards the circuit path (16) with an angle α with respect to the upper surface (23) of the contact (22) of equal or more than 50°.

5. Power semiconductor module according to any of the preceding claims, wherein at least one power semiconductor device (14) is electrically connected to a circuit path (16) via two or more bond wires (18), wherein a distance d₄ between two bond wire feet (20) of adjacent bond wires (18) lies in a range of ≤ 2mm.

6. Power semiconductor module according to any of the preceding claims, wherein at least one power semiconductor device (14) is electrically connected to a circuit path (16) via two or more bond wires (18), wherein between two first bond wire feet (20a) of adjacent bond wires (18) is a distance d₄ and wherein between at least two subsequent adjacent bond wire feet (20b) having the same priority is distance d₅, wherein d₅ is ≥ 2d₄.

7. Power semiconductor module according to any of the preceding claims, wherein at least one bond wire (18) at least partly does not proceed parallel to at least one further bond wire (18).

8. Power semiconductor module according to any of the preceding claims, wherein at least one power semiconductor device (14) is electrically connected to a circuit path (16) via two or more bond wires (18), wherein at least two bond wires (18) are provided having a different length.

9. Power semiconductor module according to any of the preceding claims, wherein at least one power semiconductor device (14) is electrically connected to a circuit path (16) via two or more bond wires (18), wherein at least two different bond wires (18) are provided having a different number of bond wire feet (20).

10. Power semiconductor arrangement, comprising a plurality of power semiconductor modules (10) according to any of the preceding claims.
